# EUROPÄISCHE PATENTSCHRIFT

(11) **EP 2 609 799 B1**
(45) Veröffentlichungstag und Bekanntmachung des Hinweises auf die Patenterteilung: **18.03.2020**
(21) Anmeldenummer: 11749779.2
(22) Anmeldetag: 03.08.2011
(51) Int. Cl.: H05K 7/14

(54) **VERSCHLUSSSYSTEM FÜR BAUGRUPPEN AM GEHÄUSE UND MONTAGEVERFAHREN**
CLOSURE SYSTEM FOR SUBASSEMBLIES AND ASSEMBLY METHOD
SYSTÈME DE FERMETUREPOUR MODULES ET PROCÉDÉ D'ASSEMBLAGE

(30) Priorität: 23.08.2010 DE 102010035101
(43) Veröffentlichungstag der Anmeldung: 03.07.2013
(73) Patentinhaber: Rohde & Schwarz GmbH & Co. KG, 81671 München (DE)
(72) Erfinder: HINGRAINER, Helmut, 83064 Raubling (DE); MUHR, Hermann, 94267 Prackenbach (DE); FISCHL, Andreas, 94244 Geiersthal (DE)
(74) Vertreter: Körfer, Thomas
(86) Internationale Anmeldenummer: PCT/EP2011/063378
(87) Internationale Veröffentlichungsnummer: WO 2012/025354

(56) Entgegenhaltungen:
- WO-A1-00/59279
- DE-A1- 2 647 362
- DE-C2- 2 903 176
- GB-A- 2 201 453

## Beschreibung

Die Erfindung betrifft ein Verschlusssystem und ein Verfahren zum Montieren und Sichern von Baugruppen an einem Gehäuse.

Geräte allgemein und elektronische Messgeräte im Besonderen sind meist aus einzelnen Modulen oder Baugruppen aufgebaut. Diese sind in einem Gehäuse über Steckverbindungen zu einer zentralen Baugruppe miteinander verbunden. Somit ist eine flexible Zusammensetzung des Geräts aus unterschiedlichen Baugruppen oder Erweiterungen durch neue Baugruppen sowie einfache Montage und Reparaturarbeiten möglich. Insbesondere elektronische Baugruppen sind über vielpoligen Stecker mit einer zentralen Baugruppe verbunden. Um einen guten elektrischen Kontakt zu gewährleisten, sitzen Stecker und Buchse fest zusammen und können nur mit Hilfsmitteln voneinander gelöst werden.

Die DE 10 2007 041 406 A1 beschreibt eine Verriegelungseinrichtung für ein Gehäuse zur Aufnahme eines Einsteckmoduls. Die Verriegelungseinrichtung ist dabei in dem Bereich des Gehäuses eingelegt, in dem der Gegenstecker integriert ist. Beim Einschieben des Einsteckmoduls rasten Füße neben der Steckverbindung in die Verriegelungseinrichtung ein und sichern somit das Einsteckmodul in Stecker und Gehäuse. Zum Lösen des Einsteckmoduls greift ein Betätigungselement in die Verriegelungseinrichtung ein, löst die Rastverbindung und hebt das Einsteckmodul aus dem Gegenstecker heraus.

Um bei dieser Anordnung ein Einsteckmodul zu lösen, muss der Bereich der Steckverbindung frei zugänglich sein. Dies erfordert in vielen Fällen das Abnehmen des umgebenden Gehäuses und ist mit einem hohen Platzbedarf verbunden. Sind mehrere Einsteckmodule dicht nebeneinander angeordnet, sind die einzelnen Steckplätze nur schwer erreichbar.

Die GB 2 201 453 A offenbart ein Mainframe, in das elektronische Module aufgenommen werden. Ein Modul umfasst ein Frontpanel, an dem eine Leiterplatte mittels Rahmen und Clip befestigt wird. Der Clip befestigt einerseits die Leiterplatte bzw. den diese Leiterplatte tragenden Rahmen mittels Schraubverbindungen am Frontpanel und umfasst andererseits eine Rastvorrichtung zum Einrasten des Moduls im Mainframe. Zum Entnehmen des Moduls aus dem Mainframe ist ein U-förmig gebogenes Werkzeug erforderlich, welches an zwei Stellen in das Frontpanel eingreift und die Verrastung der Rastvorrichtungen im Mainframe löst. Die Rastvorrichtungen verrasten im Werkzeug, so dass das Modul durch Zurückziehen des Werkzeugs herausgenommen werden kann.

Das Dokument DE 29 03 176 C2 offenbart ein Verschlusssystem zum Montieren und Sichern von Baugruppen an einem Gehäuse gemäß dem Oberbegriff des Anspruches 1.

Es ist somit die Aufgabe der vorliegenden Erfindung, ein Verschlusssystem und ein Montageverfahren zu schaffen, bei dem Baugruppen einfach und mit geringem Platzverbrauch, in ein Gehäuse und in eine darin befindliche Steckverbindungen eingesetzt und insbesondere wieder gelöst werden können. Dabei soll dabei sichergestellt sein, dass die Baugruppen sicher im Gehäuse sitzen und nur von berechtigten Personen aus dem Gehäuse entnommen werden können.

Die Aufgabe wird durch das erfindungsgemäße Verschlusssystem gemäß Anspruch 1 bzw. durch das Verfahren zum Verschließen einer Baugruppe an einem Gehäuse gemäß Anspruch 11 gelöst. In den Unteransprüchen sind vorteilhafte Weiterbildungen des erfindungsgemäßen Systems bzw. Verfahrens dargestellt.

Das erfindungsgemäße Verschlusssystem zum Montieren und Sichern von Baugruppen an einem Gehäuse umfasst mindestens eine Baugruppe, die von einem Chassis umgeben ist und an einer Rückseite eine Steckverbindung aufweist. Die der Rückseite gegenüberliegende Stirnseite der Baugruppe weist eine mit dem Chassis verbundene Chassis-Blende auf. Jede Baugruppe ist an einem Gehäuse, in das die Baugruppe eingeschoben ist, durch eine Rastvorrichtung arretierbar. Um die Rastvorrichtung zu lösen, greift ein Öffnungswerkzeug in die Chassis-Blende ein. Durch das Öffnungswerkzeug ist eine Zugbelastung auf die Chassis-Blende ausübbar und die Baugruppe aus dem Gehäuse bewegbar.

Somit kann die Baugruppe durch Angreifen an der der Steckverbindung gegenüberliegenden Stirnseite gelöst werden, so dass ein die Baugruppen und die Steckverbindung umgebendes Gehäuse beim Ein- und Ausbau einer Baugruppe an Ort und Stelle verbleiben kann. Ist ein entsprechendes Gerät zum Beispiel in einem Rack eingebaut, so ist weder ein Ausbau des Gerätes aus dem Rack noch eine Abnahme des Gehäusedeckels notwendig. Gleichzeitig wird durch die Rastverbindung zwischen Gehäuse und Baugruppe ein sicherer Sitz der Baugruppe in der Steckverbindung und im Gehäuse selbst gewährleistet. Lediglich mit dem erfindungsgemäßen Öffnungswerkzeug kann die Rastverbindung gelöst und die Baugruppe entnommen werden, sodass eine unbefugte Entnahme verhindert oder zumindest erheblich erschwert wird.

Vorteilhafterweise greifen mindestens zwei Öffnungswerkzeuge jeweils eines in einen Randbereich der Chassis-Blende ein. Die Chassis-Blende selbst weist an diesen zwei gegenüberliegenden Seiten jeweils eine Seitenwand, die senkrecht zur Chassis-Blende angeordnet ist, auf. An jeder Seitenwand ist jeweils eine Rastvorrichtung angebracht. Die Rastvorrichtungen an den beiden Seitenwänden stellen sicher, dass die Baugruppe senkrecht zur Chassis-Blende und damit parallel zu den Seitenwänden des Gehäuses in der Steckverbindung und im Gehäuse sitzt. Dies gewährleistet einen guten Kontakt der Steckverbindung und verringert eine mechanische Belastung auf die Steckverbindung.

Die an beiden Randbereichen der Chassis-Blende eingreifenden Öffnungswerkzeuge stellen eine Zugbelastung senkrecht zur Steckverbindung sicher und verhindern durch gleichmäßig an beiden Seiten der Chassis-Blende wirkende Zugkräfte ein einfaches Lösen aus der Steckverbindung.

Die Rastvorrichtung weist entweder eine oder alternativ mindestens zwei Rastnasen auf. Dabei sind die mindestens zwei Rastnasen in einem Abstand voneinander über die Breite der Chassis-Blende der Seitenwand der Chassis-Blende verteilt angeordnet und greifen in Ausnehmungen in der Seitenwand der Chassis-Blende und der Gehäusewand ein. Somit sind eine sichere Arretierung der Baugruppe und eine Ausrichtung der Baugruppe senkrecht zur Ebene in der die Rastnasen angeordnet sind, sichergestellt.

Es ist weiterhin von Vorteil, dass die Rastvorrichtung aus einem elastischen Material besteht und einen Doppelfalz in Stufenform, der parallel zur Chassis-Blende ausgerichtet ist, aufweist. Eine parallel zur Chassis-Blende gerichtete Kraft auf den dem Chassis-Boden zugewandten Teil der Rastvorrichtung führt zu einer Aufweitung insbesondere des von der Seitenwand abgewandten Falzes und vermindert somit die mechanisch Kraft auf die Befestigungsstelle der Rastvorrichtung an der Seitenwand. Dies bewirkt einen geringeren Verschleiß dieses Bauteils.

Vorteilhafterweise weist das Öffnungswerkzeug ein hakenförmiges Eingriffselement, einen Drehgriff sowie ein Zugelement auf, wobei zwischen Eingriffselement und Drehgriff ein erstes und ein zweites Zwischenelement drehbar gelagert angeordnet ist. Das erste Zwischenelement ist dabei vorteilhafterweise aus einem ersten, weichen Material und dient als Verkratzschutz, wobei das zweite Zwischenelement aus einem zweiten, reibungsarmen Material besteht, auf dem ein Gleiten sowohl des ersten Zwischenelements als auch des Drehgriffs möglich ist. Auch nach häufiger Betätigung des Verschlusselementes wird die Chassis-Blende weder verkratzt noch abgerieben, sodass ein Verschleiß der Chassis-Blende im Drehbereich des Öffnungswerkzeugs verringert wird. Gleichzeitig bleibt die Chassis-Blende optisch unversehrt und ansehnlich.

Das erfinderische Verfahren zum Montieren und Sichern einer Baugruppe an einem Gehäuse weist mindestens eine Baugruppe auf, die von einem Chassis umgeben ist und an einer Rückseite eine Steckverbindung, an der, der Rückseite gegenüberliegenden Stirnseite eine Chassis-Blende vorhanden ist. Die Baugruppe wird in das Gehäuse eingeschoben und durch eine Rastverbindung arretiert. Vorteilhafterweise wird die Rastverbindung durch Drehen eines Öffnungswerkzeugs, das in die Chassis-Blende eingreift, gelöst. Über eine Zugbelastung des Öffnungswerkzeugs auf die Chassis-Blende wird die Baugruppe dann aus dem Gehäuse bewegt. Somit kann eine Baugruppe bei geringstem Platzverbrauch einfach aus einem Gehäuse gelöst und beschädigungsfrei sowie mit wenig Kraftaufwand aus der Steckverbindung herausgezogen werden.

Die Erfindung wird im Folgenden anhand eines Ausführungsbeispiels und mit Bezug auf die Zeichnungen näher erläutert. Es zeigen:
- Fig. 1a: Ein erfindungsgemäßes Ausführungsbeispiel des Verschlusssystems in arretiertem Zustand in schematischer Darstellung;
- Fig. 1b: das erfindungsgemäße Ausführungsbeispiel des Verschlusssystems in geöffnetem Zustand;
- Fig. 2: ein erfindungsgemäßes Ausführungsbeispiel einer Rastvorrichtung in perspektivischer Ansicht;
- Fig. 3: eine erfindungsgemäße Gehäusewand in Draufsicht;
- Fig. 4a: ein Ausführungsbeispiel einer erfindungsgemäßen Chassis-Blende im arretierten Zustand in Draufsicht von der Baugruppe aus;
- Fig. 4b: eine erfindungsgemäße Chassis-Blende entsprechend Fig.4a im geöffneten Zustand und
- Fig. 5: ein erfindungsgemäßes Ausführungsbeispiel einer Chassis-Blende in Blickrichtung auf die Baugruppe.

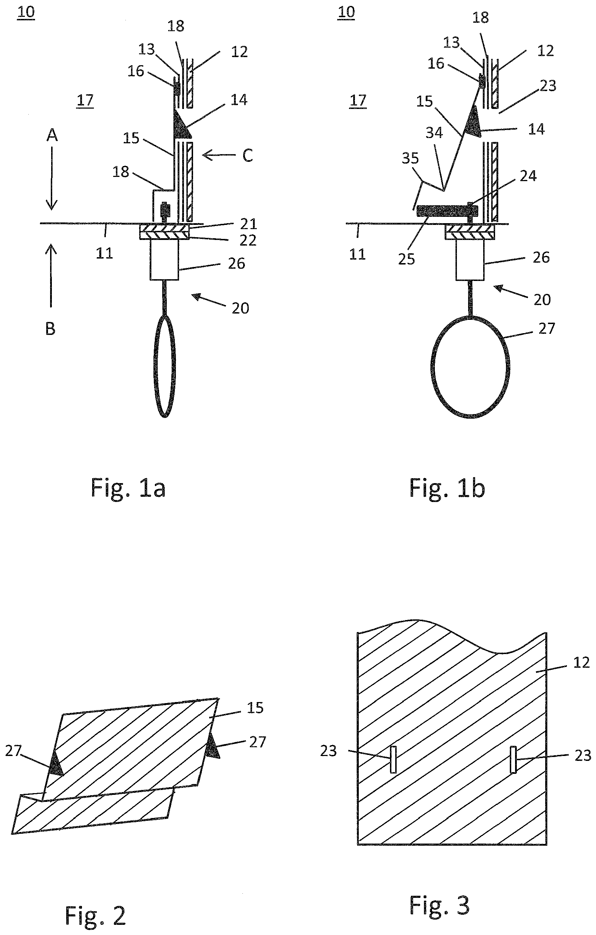

Nachfolgend werden anhand von Fig. 1a und 1b das gesamte Verschlusssystem und seine Funktionsweise beschrieben, wohingegen Fig. 2,3,4a,4b und Fig. 5 einzelne Komponenten im Detail zeigen. Einander entsprechende Teile sind in allen Figuren mit den gleichen Bezugszeichen versehen.

Das in Fig. 1a dargestellte Verschlusssystem 10 umfasst ein Gehäuse 12 in das eine Baugruppe 17 eingeschoben und in dieser arretiert ist. Die nicht näher dargestellte Baugruppe 17 wird von einem Chassis umgeben, von dem hier ein Seitenelement 18 dargestellt ist. Das Chassis-Seitenelement 18 und die Chassis-Blende 11 sind vorzugsweise fest, aber lösbar miteinander verbunden. So kann die Chassis-Blende 11 beispielsweise auf die Chassis-Seitenwand 18 aufgesteckt sein und zum Beispiel durch Schraubenverbindung oder Rastverbindung aneinander gesichert sein. Die Chassis-Blende 11 weist zwei gegenüberliegenden Seitenwänden 13 auf, die fest mit der Chassis-Blende 11 verbunden sind. Die Seitenwände 13 der Chassis-Blende 11 sind bevorzugt entlang der Schmalseite der Baugruppe 17 an der Chassis-Blende 11 angeordnet.

In einem Abstand von der Chassis-Blende 11 ist an der Seitenwand 13 eine Rastvorrichtung 15 an einer Befestigungsstelle 16 fixiert. Die Rastvorrichtung 15 kann dabei durch Schweißen, Löten, Kleben, Nieten oder auch durch Schrauben an mehreren Punkten oder kontinuierlich über die Seitenwand verteilt an der Seitenwand fixiert sein. Die Rastvorrichtung 15 besteht aus einem elastischen Material zum Beispiel einem Metallstreifen, der in einem von der Befestigungsstelle 16 abgewandten Bereich einen Doppelfalz 34, 35 (siehe Fig. 1b) aufweist, der parallel zur Chassis-Blende verläuft und eine Stufe 18 ausbildet.

Im zur Befestigungsstelle 16 zugewandten Bereich der Rastvorrichtung 15 ist eine Rastnase 14 ausgebildet, die in jeweils eine Ausnehmung 23 in der Seitenwand 13 der Chassis-Blende 11, in eine Ausnehmung 23 des Chassis-Seitenelements 18 sowie in eine Ausnehmung 23 des Gehäuses 12 eingreift. In einem bevorzugten Ausführungsbeispiel des Verschlusssystems weist die Rastvorrichtung 15, die in Fig. 2 aus Blickrichtung C dargestellt wird, zwei Rastnasen 14 auf, die jeweils am Rand der Rastvorrichtung 15 angeordnet sind. Die Rastvorrichtung 15 sowie die Rastnasen 14 können in einfacher Weise einstückig ausgeführt sein, wobei die Rastnasen durch Biegen gefertigt werden. Diese stellt eine preiswerte und haltbare Ausführung der Rastvorrichtung dar.

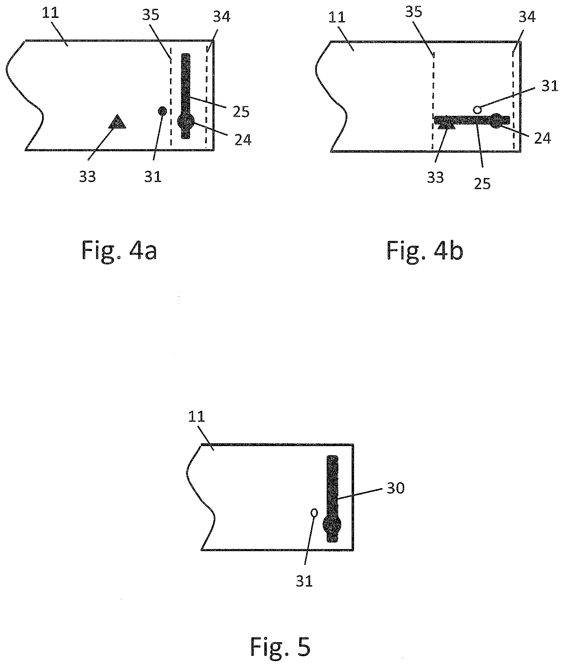

Durch eine Eingriffsöffnung 30, siehe Fig. 5, wird ein Öffnungswerkzeug 20 in die Chassis-Blende eingeführt. Ein erstes Zwischenelement 21, das aus einem ersten, weichen Material besteht, liegt an der Chassis-Blende auf. Das erste Zwischenelement 21 kann z.B. aus einem weichen Elastomer bestehen. Ein an das erste Zwischenelement angrenzendes zweites Zwischenelement 22 besteht aus einem reibungsarmen, glatten Material und ermöglicht somit das Drehen eines Drehgriffs 26 ohne das erste Zwischenelement 21 mit zu bewegen. Somit bleibt die Oberfläche der Chassis-Blende 11 unverkratzt und auch bei häufiger Verwendung des Öffnungswerkzeugs 20 unbeschädigt.

Fig. 1b zeigt das Verschlusssystem 10, das in Fig. 1a im verschlossenen Zustand dargestellt ist, im geöffneten Zustand. Dabei wurde der Bart 25 des hakenförmigen Eingriffselements 24 auf die dargestellte Öffnungsposition durch Drehen des Öffnungswerkzeugs 20, insbesondere des Drehgriffs 26, gebracht. Dabei führt der Bart 25 die Rastvorrichtung 15 von der Seitenwand 13 weg und zieht dabei die Rastnase 14 aus der Ausnehmung 23 in der Seitenwand 13, dem Chassis-Seitenelement 18 und dem Gehäuse 12 heraus. Die Ausnehmungen 23 im Gehäuse 12 sind in Fig. 3 dargestellt, die die Gehäusewand 12 aus der Blickrichtung C, wie in Fig.1A eingezeichnet, zeigt. Durch ziehen am Zugelement 27 des Öffnungswerkzeugs 20 kann die Baugruppe 17 aus dem Gehäuse 12 herausgezogen werden.

Drehgriff 26 und Zugelement 27 können drehfest in schlüsselähnlicher Form gekoppelt sein, sodass das Zugelement auch zur Ausübung eines Drehmoments dient. Bei einer losen Verbindung zwischen Drehgriff 26 und Zugelement 27 kann das Zugelement z.B. zu einer Schlaufe vergrößert sein und zur Ausübung einer starken Zugkraft verwendet werden.

In Fig. 4a ist die Chassis-Blende 11 in Draufsicht entsprechend dem Pfeil A in Fig. 1a abgebildet. Zwischen dem ersten Falz 34 und dem zweiten Falz 35 der Rastvorrichtung 15, die durch gestrichelte Linien angedeutet sind, befindet sich das Eingriffselement 24, wobei der Bart 25 parallel zum ersten und zweiten Falz 34, 35 ausgerichtet ist. Die Rastvorrichtung 15 ist somit eingerastet. Eine Bohrung in der Chassis-Blende 11 bildet eine Anzeigeöffnung 31. Da kaum Licht aus dem Inneren der Baugruppe durch die Anzeigeöffnung tritt, erscheint diese dunkel.

Fig. 4b zeigt die Chassis-Blende 11 mit einem Eingriffselement 24, dessen Bart 25 in einer nach links gedrehten Position weist. Ein Überdrehen des Bartes 25 über die Maximalstellung hinaus wird durch einen Anschlag 33 in Form eines Überstands von der Chassis-Blende 11 verhindert. Da nun Licht von der Rastvorrichtung 15 reflektiert wird, erscheint die Anzeigeöffnung 31 hell. Andere Anzeigemechanismen, z.B. durch farbliche Hinterlegung der Anzeigeöffnung, sind ebenso möglich. Vorteilhafterweise wird die Anzeigeöffnung 31 in geringem Abstand vom zweiten Falz 35 der Rastvorrichtung 15 in der Chassis-Blende 11 angebracht, da somit erst bei einem vollständigen Einrasten der Rastnase 14 in die Ausnehmungen 23 die Rastvorrichtung 15 als geschlossen angezeigt wird. Ein lediglich teilweises Einrasten ist somit sichtbar und kann besser vermieden werden.

Fig. 5 zeigt die Chassis-Blende 11 in Draufsicht in Richtung B, wie in Fig. 1a symbolisiert ist. Es ist die Eingriffsöffnung 30 zu sehen, in die das Eingriffselement 24 des Öffnungswerkzeugs 20 eingreifen kann. Die Kontur der Eingriffsöffnung 30 kann vielfältig von der dargestellten rechteckigen Form abweichen, sodass die Rastvorrichtung 15 lediglich mit einem Eingriffselements 24 mit einem Bart 25 mit entsprechender Kontur geöffnet werden kann. Dadurch kann der Zugriff auf die Baugruppen in einfacher Weise beschränkt werden.

Alle beschriebenen und/oder bezeichneten Merkmale können im Rahmen der Erfindung vorteilhaft miteinander kombiniert werden. Die Erfindung ist nicht auf die dargestellten Ausführungsbeispiele beschränkt. Beispielsweise kann es ausreichend sein, nur ein Bauelement vorzunehmen.

## Patentansprüche

1. Verschlusssystem zum Montieren und Sichern von Baugruppen (17) an einem Gehäuse (12),
wobei mindestens eine Baugruppe (17), die von einem Chassis umgeben ist, an einer Rückseite eine Steckverbindung aufweist und an der der Rückseite gegenüberliegenden Stirnseite eine mit dem Chassis verbundene Chassis-Blende (11) aufweist,
wobei jede Baugruppe (17) an einem Gehäuse (12), in das die Baugruppe (17) eingeschoben ist, durch zumindest zwei Rastvorrichtungen (15) arretierbar ist,
wobei die Chassis-Blende (11) an zwei gegenüberliegenden Seiten jeweils eine Seitenwand (13) senkrecht zur Chassis-Blende (11) aufweist und an jeder Seitenwand (13) jeweils eine der beiden Rastvorrichtungen (15) angebracht ist, und
wobei jede Rastvorrichtung (15) mit einem Öffnungswerkzeug (20), das in die Chassis-Blende (11) eingreift, lösbar ist,
wobei jede Rastvorrichtung (15) mindestens eine Rastnase (14) aufweist,
**dadurch gekennzeichnet,**
**dass** die Seitenwand (13) der Chassis-Blende (11) und das Gehäuse (12) jeweils Ausnehmungen (23) aufweisen, in die die Rastnasen (14) eingreifen.

2. Verschlusssystem nach Anspruch 1
wobei durch das Öffnungswerkzeug (20) eine Zugbelastung auf die Chassis-Blende (11) ausübbar und die Baugruppe (17) aus dem Gehäuse (12) bewegbar ist.

3. Verschlusssystem nach Anspruch 1 oder 2
wobei mindestens zwei Öffnungswerkzeuge in jeweils einander gegenüberliegende Randbereiche der Chassis-Blende (11) eingreifen.

4. Verschlusssystem nach Anspruch 1
wobei jede Rastvorrichtung (15) mindestens zwei Rastnasen (14) aufweist, die in einem Abstand voneinander über die Breite der Seitenwand (13) der Chassis-Blende (11) verteilt angeordnet sind.

5. Verschlusssystem nach einem der Ansprüche 1 bis 4
wobei jede Rastvorrichtung (15) aus einem elastischen Material besteht.

6. Verschlusssystem nach einem der Ansprüche 1 bis 5
wobei jede Rastvorrichtung (15) einen Doppelfalz in Stufenform, der parallel zur Chassis-Blende (11) ausgerichtet ist, aufweist.

7. Verschlusssystem nach Anspruch 6,
wobei die Chassis-Blende (11) eine Anzeigeöffnung (31) aufweist und die Anzeigeöffnung (31) in einem Bereich der Chassis-Blende (11) angeordnet ist, der bei Arretierung der Baugruppe (17) im Gehäuse (12) von der Rastvorrichtung (15) nicht überdeckt und bei vollständig gelöster Arretierung von der Rastvorrichtung (15) überdeckt ist.

8. Verschlusssystem nach einem der vorhergehenden Ansprüche
wobei das Öffnungswerkzeug (20) ein hakenförmiges Eingriffselement (24), einen Drehgriff (26) sowie ein Zugelement (27) aufweist und zwischen Eingriffselement (24) und Drehgriff (26) ein erstes Zwischenelement (21) und ein zweites Zwischenelement (22) drehbar gelagert angeordnet sind.

9. Verschlusssystem nach Anspruch 8
wobei das erste Zwischenelement (21) aus einem ersten, weichen Material besteht und als Verkratzschutz dient und das zweite Zwischenelement (22) aus einem zweiten, reibungsarmen Material besteht, auf dem das erste Zwischenelement (21) und der Drehgriff (26) gleiten.

10. Verschlusssystem nach Anspruch 8 oder 9 wobei der Drehgriff (26) und das Zugelement (27) einteilig ausgebildet sind.

11. Verfahren zum Montieren und Sichern einer Baugruppe (17) an einem Gehäuse (12),
wobei mindestens eine Baugruppe (17), die von einem Chassis umgeben ist, an einer Rückseite eine Steckverbindung aufweist und an der der Rückseite gegenüberliegenden Stirnseite eine Chassis-Blende (11) aufweist,
wobei die Baugruppe (17) in das Gehäuse (12) eingeschoben und durch zwei Rastvorrichtungen (15) arretiert wird,
wobei die Chassis-Blende (11) an zwei gegenüberliegenden Seiten jeweils eine Seitenwand (13) senkrecht zur Chassis-Blende (11) aufweist und an jeder Seitenwand (13) jeweils eine der beiden Rastvorrichtungen (15) angebracht ist,
wobei die Seitenwand (13) der Chassis-Blende (11) und das Gehäuse (12) jeweils Ausnehmungen (23) aufweisen, in die Rastnasen (14) eingreifen,
und wobei jede Rastvorrichtung (15) durch Betätigen eines Öffnungswerkzeugs (20), das in die Chassis-Blende (11) eingreift, gelöst wird.

12. Verfahren nach Anspruch 11,
wobei durch Drehen des Öffnungswerkzeugs (20), das in die Chassis-Blende (11) eingreift, die Rastvorrichtung (15) gelöst wird.

13. Verfahren nach Anspruch 11 oder 12,
wobei über eine Zugbelastung des Öffnungswerkzeugs (20) auf die Chassis-Blende (11) die Baugruppe (17) aus dem Gehäuse (12) bewegt wird.

## Claims

1. Closure system for mounting and securing subassemblies (17) on a housing (12),
wherein at least one subassembly (17), enclosed by a chassis, has a plug-in connection on a rear side and has a chassis front-plate (11), which is connected to the chassis, on the end side which is located opposite the rear side,
wherein each subassembly (17) can be arrested on a housing (12), into which the subassembly (17) has been pushed, by at least two latching devices (15),
wherein, on two opposite sides, the chassis front-plate (11) has a respective side wall (13) in a direction perpendicular to the chassis front-plate (11), and in each case one of the two latching devices (15) is fitted on each side wall (13), and wherein each latching device (15) can be released by an opening tool (20), which engages in the chassis front-plate (11),
wherein each latching device (15) has at least one latching nose (14),
**characterized**
**in that** the side wall (13) of the chassis front-plate (11) and also the housing (12) each have apertures (23), in which the latching noses (14) engage.

2. Closure system according to Claim 1,
wherein the chassis front-plate (11) can be subjected to tensile loading, and the subassembly (17) can be moved out of the housing (12), by the opening tool (20).

3. Closure system according to Claim 1 or 2,
wherein at least two opening tools engage in respectively opposite peripheral regions of the chassis front-plate (11).

4. Closure system according to Claim 1,
wherein each latching device (15) has at least two latching noses (14), which are distributed at a distance apart from one another over the width of the side wall (13) of the chassis front-plate (11).

5. Closure system according to one of Claims 1 to 4,
wherein each latching device (15) consists of an elastic material.

6. Closure system according to one of Claims 1 to 5,
wherein each latching device (15) has a step-form double fold, which is oriented parallel to the chassis front-plate (11).

7. Closure system according to Claim 6,
wherein the chassis front-plate (11) has an indicator opening (31), and the indicator opening (31) is arranged in a region of the chassis front-plate (11) which is not covered over by the latching device (15) when the subassembly (17) is arrested in the housing (12) and is covered over by the latching device (15) when arresting operation has been fully released.

8. Closure system according to one of the preceding claims,
wherein the opening tool (20) has a hook-like engagement element (24), a rotary handle (26) and a pulling element (27), and a first intermediate element (21) and a second intermediate element (22) are mounted in a rotatable manner between the engagement element (24) and rotary handle (26).

9. Closure system according to Claim 8,
wherein the first intermediate element (21) consists of a first, soft material, and serves as a scratch guard, and the second intermediate element (22) consists of a second, low-friction material, on which the first intermediate element (21) and the rotary handle (26) slide.

10. Closure system according to Claim 8 or 9,
wherein the rotary handle (26) and the pulling element (27) are formed in one piece.

11. Method for mounting and securing a subassembly (17) on a housing (12),
wherein at least one subassembly (17), enclosed by a chassis, has a plug-in connection on a rear side and has a chassis front-plate (11) on the end side which is located opposite the rear side,
wherein the subassembly (17) is pushed into the housing (12) and arrested by two latching devices (15),
wherein, on two opposite sides, the chassis front-plate (11) has a respective side wall (13) in a direction perpendicular to the chassis front-plate (11), and in each case one of the two latching devices (15) is fitted on each side wall (13),
wherein the side wall (13) of the chassis front-plate (11) and also the housing (12) each have apertures (23), in which latching noses (14) engage, and wherein each latching device (15) is released by actuation of an opening tool (20), which engages in the chassis front-plate (11).

12. Method according to Claim 11,
wherein the latching device (15) is released by rotation of the opening tool (20), which engages in the chassis front-plate (11).

13. Method according to Claim 11 or 12,
wherein the subassembly (17) is moved out of the housing (12) by virtue of the chassis front-plate (11) being subjected to tensile loading by the opening tool (20).

## Revendications

1. Système de fermeture pour le montage et la fixation de modules (17) sur un boîtier (12),
dans lequel au moins un module (17), qui est entouré par un châssis, présente sur une face arrière une fiche de raccordement et sur la face frontale opposée à la face arrière un cache de châssis (11) relié au châssis,
dans lequel chaque module (17) peut être bloqué sur un boîtier (12), dans lequel le module (17) est introduit, par au moins deux dispositifs d'encliquetage (15),
dans lequel le cache de châssis (11) présente sur deux faces opposées respectivement une paroi latérale (13) perpendiculaire au cache de châssis (11) et respectivement un des deux dispositifs d'encliquetage (15) est monté sur chaque paroi latérale (13), et dans lequel chaque dispositif d'encliquetage (15) peut être libéré avec un outil d'ouverture (20), qui s'insère dans le cache de châssis (11),
dans lequel chaque dispositif d'encliquetage (15) présente au moins un ergot d'encliquetage (14),
**caractérisé en ce**
**que** la paroi latérale (13) du cache de châssis (11) et le boîtier (12) présentent respectivement des évidements (23), dans lesquels les ergots d'encliquetage (14) s'insèrent.

2. Système de fermeture selon la revendication 1
dans lequel une contrainte de traction peut être exercée sur le cache de châssis (11) par l'outil d'ouverture (20) et le module (17) peut être déplacé à l'extérieur du boîtier (12).

3. Système de fermeture selon la revendication 1 ou 2
dans lequel au moins deux outils d'ouverture s'insèrent dans des zones de bord respectivement opposées les unes aux autres du cache de châssis (11).

4. Système de fermeture selon la revendication 1
dans lequel chaque dispositif d'encliquetage (15) présente au moins deux ergots d'encliquetage (14), qui sont disposés à distance l'un de l'autre de manière répartie sur la largeur de la paroi latérale (13) du cache de châssis (11).

5. Système de fermeture selon l'une quelconque des revendications 1 à 4
dans lequel chaque dispositif d'encliquetage (15) est constitué d'un matériau élastique.

6. Système de fermeture selon l'une quelconque des revendications 1 à 5
dans lequel chaque dispositif d'encliquetage (15) présente un double pli de forme étagée, qui est orienté parallèlement au cache de châssis (11).

7. Système de fermeture selon la revendication 6,
dans lequel le cache de châssis (11) présente une ouverture d'affichage (31) et l'ouverture d'affichage (31) est disposée dans une zone du cache de châssis (11) qui n'est pas recouverte par le dispositif d'encliquetage (15) lors du blocage du module (17) dans le boîtier (12) et qui est recouverte par le dispositif d'encliquetage (15) lorsque le blocage est entièrement libéré.

8. Système de fermeture selon l'une quelconque des revendications précédentes
dans lequel l'outil d'ouverture (20) présente un élément d'insertion (24) en forme de crochet, une poignée tournante (26) ainsi qu'un élément de traction (27) et un premier élément intermédiaire (21) et un deuxième élément intermédiaire (22) sont disposés de manière montée en rotation entre l'élément d'insertion (24) et la poignée tournante (26).

9. Système de fermeture selon la revendication 8
dans lequel le premier élément intermédiaire (21) est constitué d'un premier matériau souple et sert de protection contre les rayures et le deuxième élément intermédiaire (22) est constitué d'un deuxième matériau à faible frottement, sur lequel le premier élément intermédiaire (21) et la poignée tournante (26) glissent.

10. Système de fermeture selon la revendication 8 ou 9 dans lequel la poignée tournante (26) et l'élément de traction (27) sont réalisés d'une seule pièce.

11. Procédé de montage et de fixation d'un module (17) sur un boîtier (12),
dans lequel au moins un module (17), qui est entouré par un châssis, présente sur une face arrière une fiche de raccordement et sur la face frontale opposée à la face arrière un cache de châssis (11),
dans lequel le module (17) est introduit dans le boîtier (12) et bloqué par deux dispositifs d'encliquetage (15),
dans lequel le cache de châssis (11) présente sur deux faces opposées respectivement une paroi latérale (13) perpendiculaire au cache de châssis (11) et respectivement un des deux dispositifs d'encliquetage (15) est monté sur chaque paroi latérale (13),
dans lequel la paroi latérale (13) du cache de châssis (11) et le boîtier (12) présentent respectivement des évidements (23) dans lesquels s'insèrent des ergots d'encliquetage (14),
et dans lequel chaque dispositif d'encliquetage (15) est libéré par actionnement d'un outil d'ouverture (20), qui s'insère dans le cache de châssis (11).

12. Procédé selon la revendication 11,
dans lequel le dispositif d'encliquetage (15) est libéré par rotation de l'outil d'ouverture (20), qui s'insère dans le cache de châssis (11).

13. Procédé selon la revendication 11 ou 12,
dans lequel le module (17) est déplacé à l'extérieur du boîtier (12) sur le cache de châssis (11) par l'intermédiaire d'une contrainte de traction de l'outil d'ouverture (20).
